# EUROPEAN PATENT APPLICATION

(11) **EP 1 898 326 A1**
(43) Date of publication of application: **12.03.2008**
(21) Application number: 05752956.2
(22) Date of filing: 24.06.2005
(51) Int. Cl.: G06F 17/50

(54) **DEVICE DESIGN SUPPORT METHOD, PROGRAM, AND SYSTEM**

(71) Applicant: Fujitsu Ltd., Kawasaki-shi, Kanagawa 211-8588 (JP)
(72) Inventor: OKUWAKI, Yoshihito, FUJITSU LIMITED, Kawasaki-shi, Kanagawa 211-8588 (JP); KATOU, Yoshikazu, FUJITSU LIMITED, Kawasaki-shi, Kanagawa 211-8588 (JP)
(74) Representative: Delumeau, François Guy
(86) International application number: PCT/JP2005/011585
(87) International publication number: WO 2006/137144

(57) **Abstract**

From a component model library 16 having stored therein a three-dimensional component model created for each type of component, a component model to be implemented is created. The component model is incorporated in a three-dimensional printed-board model created based on printed-board information, thereby creating an implemented-printed-board model. A low-component-shape deleting unit (30) deletes a low-component shape having a height up to a specified height from the component models stored in the component model library (16) to reflect the deletion results onto the implemented-printed-board model. A low-component-replacement model creating unit (32) creates and incorporates, based on a component implementation area of a printed board and the specified height, a single low-component-replacement model that replaces a deleted portion of the low-component shape, thereby creating a printed-board simplified model.

## Description

This application is a continuation of PCT/JP2005/011585, filed June 24, 2005.

### Technical Field

The present invention relates to a device design supporting method, program, and system of creating a three-dimensional model of a printed board having implemented thereon electronic components for use in device package designing and, in particular, to a device design supporting method, program, and system of creating a printed-board simplified model by which electronic components incorporated on a printed board are represented in a simplified manner.

### Background Art

Conventionally, in package designing of a device, such as an information processing device using three-dimensional CAD, a three-dimensional printed-board model of a printed board to be incorporated in a package is created and captured, thereby implementing a designing operation so as to cope with downsizing and high density.

To keep the process performance of the three-dimensional CAD system in device package designing, a method of simplifying a printed-board model captured in three-dimensional CAD has been demanded.

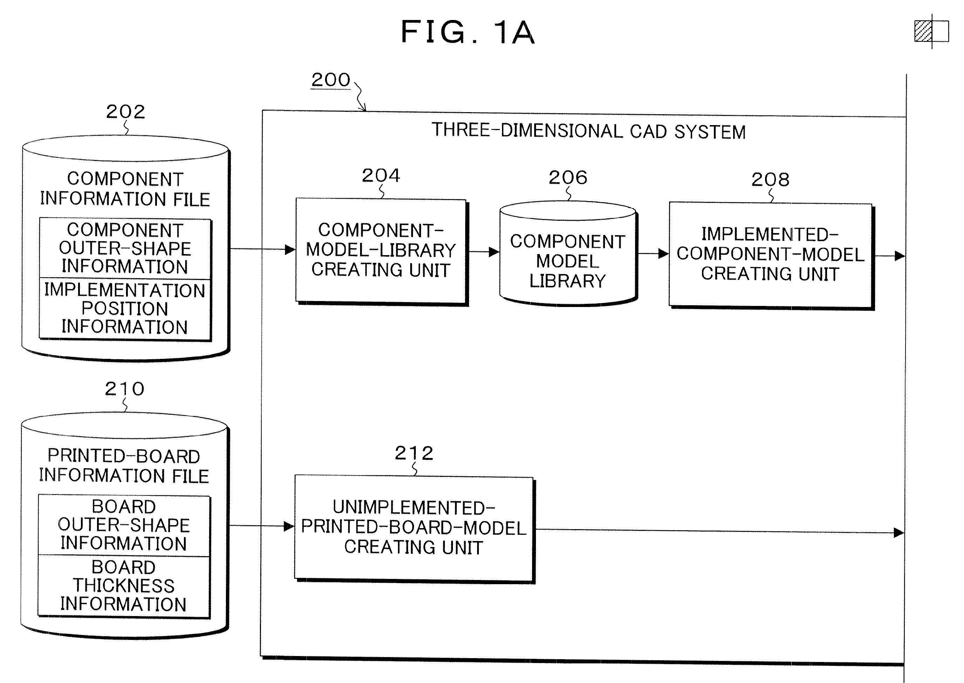

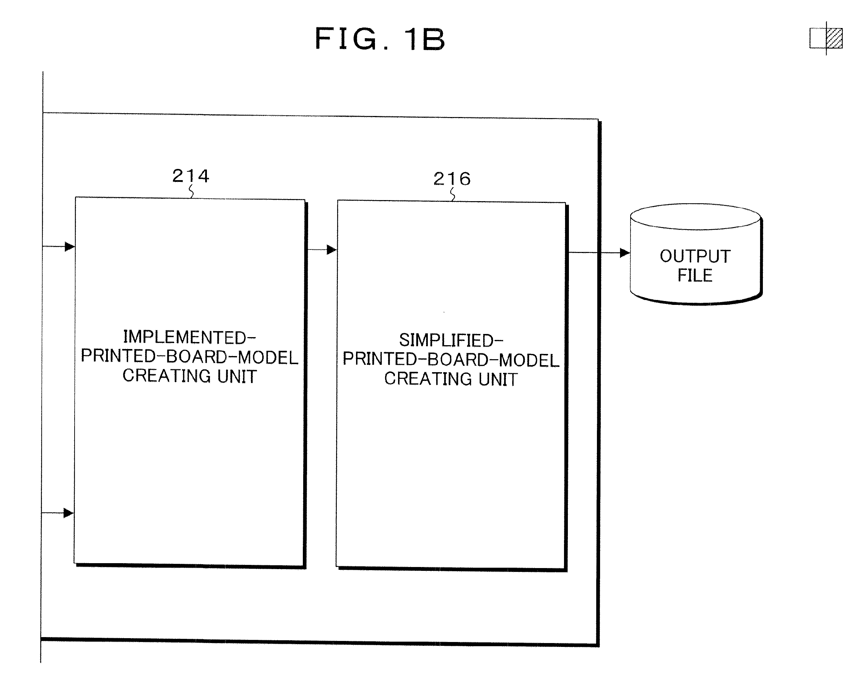

Figs. 1A and 1B depict a function of creating a printed-board model with a conventional three-dimensional CAD system. In Figs. 1A and 1B, in three-dimensional CAD 200, based on component outer-shape information of a component information file 202, a component-model-library creating unit 204 creates a three-dimensional component model for each type of component for storage in a component model library 206. An implemented-component-model creating unit 208 creates, from a component model library 206, many implementation components model to be implemented on a printed board.

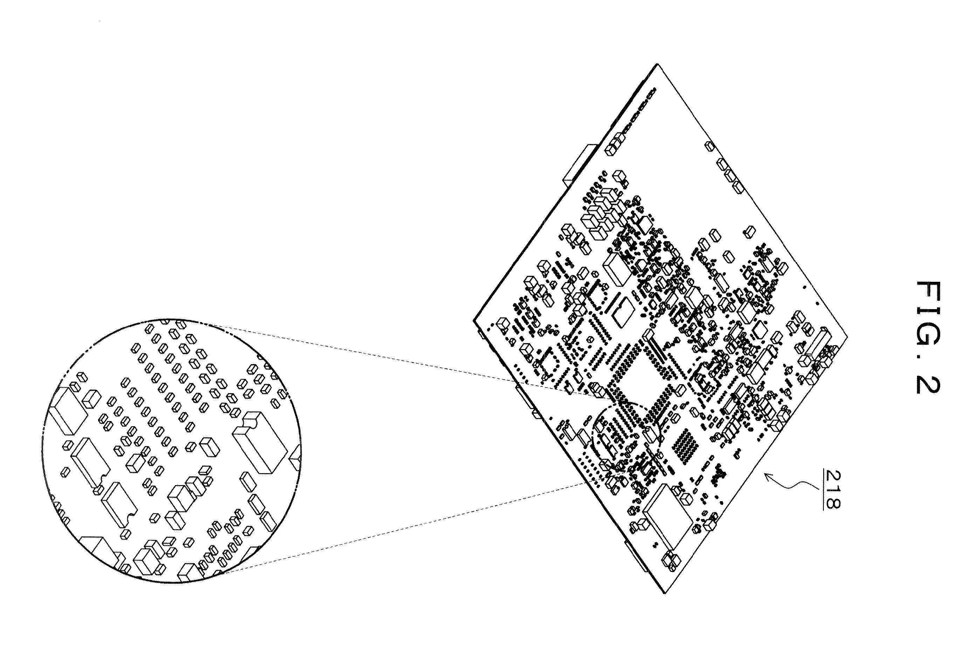

On the other hand, an unimplemented-printed-board-model creating unit 212creasesathree-dimensionalprinted-board model from board outer-shape information and board thickness information in a printed-board information file 210. An implemented-printed-board-model creating unit 214 incorporates an implemented-component model in the printed-board model created by the unimplemented-printed-board-model creating unit 212 based on implementation-position information, thereby creating, for example, an implemented printed board model 218 as in Fig. 2.

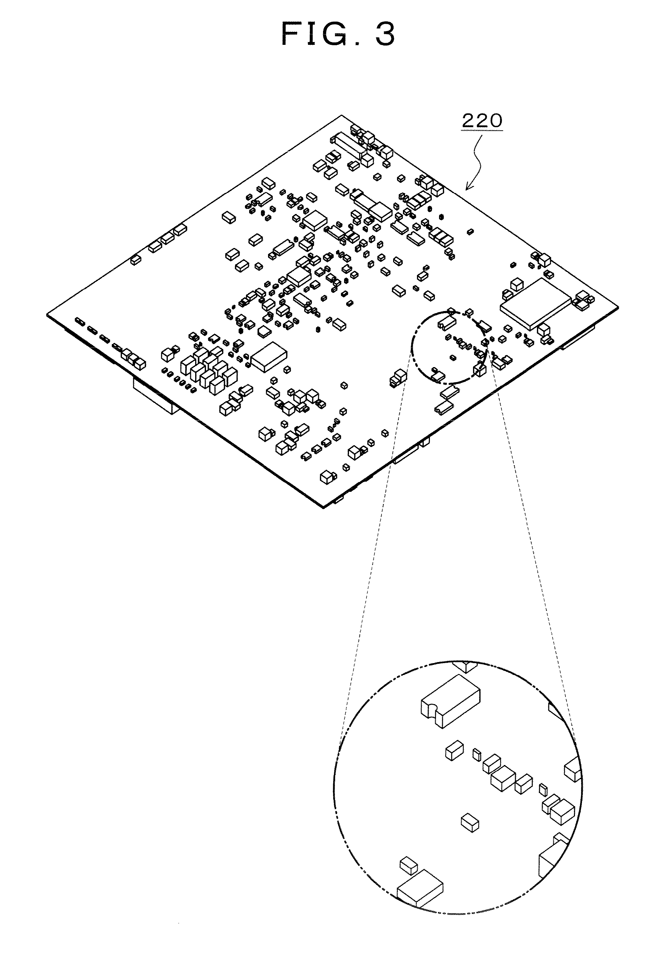

A simplified-printed-board-model creating unit 216 checks the size, for example, height, of each component mounted on the printed board, and deletes a component having a height equal to or lower than a height specified by a user, thereby creating a printed-board simplified model 220 simplified as depicted in Fig. 3, for example.

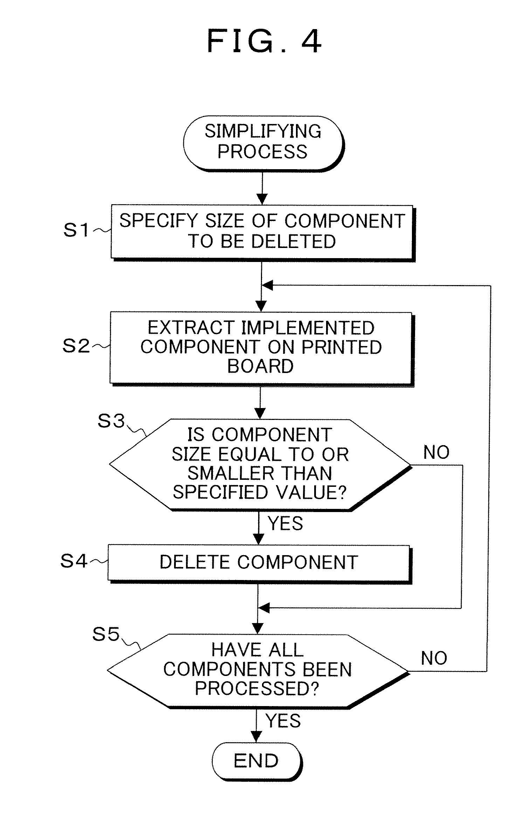

Fig. 4 is a flowchart of a conventional process of simplifying a printed-board model. In Fig. 4, the size of components to be deleted by the user, for example, height, is specified at step S1. At step S2, one of components implemented on a printed-board model completed as depicted in Fig. 2 is extracted. At step S3, whether the component size is equal to or lower than a specified value.

If the component size is equal to or lower than the specified value, that component is deleted at step S4. At step S5, this process from steps S2 to S4 is repeated until all components on the printed-board model are processed.

Such a method of checking the size of each implemented component model and deleting those having a size equal to or lower than a user-specified size has been commercialized in, for example, One Space Designer (which is a 3D-CAD system manufactured from CoCreate).

First patent document: Japanese Patent Application laid-Open Publication No. 9-237285 Second patent document: Japanese Patent Application laid-Open Publication No. 2003-167928

However, in such a conventional method of simplifying a printed-board model, as evident from Fig. 3, the printed-board model 218 to be processed has mounted thereon a huge number of electronic-component models. Since each of these component models is extracted to check the size, for example, height, one by one, thereby consuming an enormous amount of time.

Moreover, by deleting components having a size equal to or lower than the user-specified size, the printed-board simplified model 220 is created as depicted in Fig. 4, thereby reducing a process load at the time of representing a printed-board model on a display. However, if package designing proceeds by using such a simplified model obtained through component deletion, an error in design, such as interference, may occur.

This is because designing proceeds by a designer assuming that no electronic component is present at a position where the deleted electronic component is supposed to be mounted. This may cause an error in design, such as interference, between the deleted electronic components and those newly-designed, such as a package.

To implement a detailed interference check, a printed-board model before deleting the electronic components is used. However, the number of components mounted on the printed board is extremely large, thereby posing a problem of requiring an enormous amount of time for check.

An object of the present invention is to provide a device design supporting method, program, and system allowing simple component deletion and also allowing a printed-board model to be simplified to prevent an error in design, such as interference.

### Disclosure of Invention

The present invention provides a device design supporting method. The device design supporting method according to the present invention causes a computer to execute the steps including:
a printed-board model creating step of creating, from a component model library having stored therein a three-dimensional component model created for each type of component, an implemented-component model to be implemented, and incorporating the implemented-component model in a three-dimensional printed-board model created based on printed-board information to create an implemented-printed-board model;
alow-component-shape deleting step of deleting a component model having a height equal to or lower than a specified height from the component models stored in the component model library and, for a component model having a height exceeding the specified height, deleting a low-component shape having a height equal to or lower than the specified height to reflect the deletion results onto the implemented-printed-board model; and
a low-component-replacement model creating step of creating and incorporating, based on a component implementation area of a printed board and the specified height, a single low-component-replacement model that replaces a deleted portion of the component model and a deleted portion of the low-component shape, thereby creating a printed-board simplified model.

Here, the implemented-component model incorporated in the implemented-printed-board model shares data of a corresponding component model stored in the component model library, and a shape of the implement component model is changed in conjunction with a shape change of the component model.

In the low-component-replacement model creating step,
a low-component-replacement model is created and incorporated, the low-component-replacement model being in a stereoscopic shape formed by moving the component implementation area as a bottom surface by the specified height in a height direction.

In the low-component-shape deleting step, the height of the component model to be deleted is a height specified by a user through an information specifying unit.

The printed-board model creating step includes:
a library creating step of creating a three-dimensional component model for each type of component based on component information and storing the three-dimensional component model in a component model library;
an implemented-component model creating step of creating, from the component model library, an implemented-component model to be implemented on the printed board;
an unimplemented- print ed- board model creating step of creating a three-dimensional printed-board model from printed-board information; and
an implemented-printed-board model creating step of creating an implemented-printed-board model by incorporating the implemented-component model in the printed-board model.

The present invention provides a device design supporting program. The device design supporting program according to the present invention causes a computer to execute the steps including:
a printed-board model creating step of creating, from a component model library having stored therein a three-dimensional component model created for each type of component, an implemented-component model to be implemented, and incorporating the implemented-component model in a three-dimensional printed-board model created based on printed-board information to create an implemented-printed-board model;
alow-component-shapedeletingstepof deleting a component model having a height equal to or lower than a specified height from the component models stored in the component model library and, for a component model having a height exceeding the specified height, deleting a low-component shape having a height equal to or lower than the specified height to reflect the deletion results onto the implemented-printed-board model; and
a low-component-replacement model creating step of creating and incorporating, based on a component implementation area of a printed board and the specified height, a single low-component-replacement model that replaces a deleted portion of the implemented-component model and a deleted portion of the low-component shape, thereby creating a printed-board simplified model.

The present invention provides a device design supporting system. The device design supporting system according to the present invention includes:
a printed-board model creating unit that creates , from a component model library having stored therein a three-dimensional component model created for each type of component, an implemented-component model to be implemented, and incorporates the implemented-component model in a three-dimensional printed-board model created based on printed-board information to create an implemented-printed-board model;
a low-component-shape deleting unit that deletes a component model having a height equal to or lower than a specified height from the component models stored in the component model library and, for a component model having a height exceeding the specified height, deletes a low-component shape having a height equal to or lower than the specified height to reflect the deletion results onto the implemented-printed-board model; and
a low-component-replacement model creating unit that creates and incorporating, based on a component implementation area of a printed board and the specified height, a single low-component-replacement model that replaces a deleted portion of the implemented-component model and a deleted portion of the low-component shape, thereby creating a printed-board simplified model.

Here, details of the device design supporting program and system according to the present invention are basically the same as those in the case of the device design supporting method according to the present invention.

Also, in another embodiment of the device design supporting method according to the present invention, the method causes a computer to execute the steps including:
a printed-board model creating step of creating, from a component model library having stored therein a three-dimensional component model created for each type of component, an implemented-component model to be implemented, and incorporating the implemented-component model in a three-dimensional printed-board model created based on printed-board information to create an implemented-printed-board model;
a high-component model creating step of creating a component model having a height higher than a height specified from the component models stored in the component model library for reflection onto the implemented-printed-board model; and
a low-component-replacement model creating step of creating and incorporating, based on a component implementation area of a printed board and the specified height, a single low-component-replacement model that replaces a portion having a height equal to or lower than the specified height of the implemented-component model, thereby creating a printed-board simplified model.

In this device design supporting method, for a component model in the component model library, instead of deleting a portion having a height equal to or lower than the specified height, a component model having a height equal to or higher than the specified height is created and is combined with a low-component-replacement model that replaces a portion having a height lower than the specified height, thereby creating a simplified model.

Furthermore, in another embodiment of the device design supporting program according to the present invention, the program causes a computer to execute the steps including:
a printed-board model creating step of creating, from a component model library having stored therein a three-dimensional component model created for each type of component, an implemented-component model to be implemented, and incorporating the implemented-component model in a three-dimensional printed-board model created based on printed-board information to create an implemented-printed-board model;
a high-component model creating step of creating a component model having a height higher than a height specified from the component models stored in the component model library for reflection onto the implemented-printed-board model; and
a low-component-replacement model creating step of creating and incorporating, based on a component implementation area of a printed board and the specified height, a single low-component-replacement model that replaces a portion having a height equal to or lower than the specified height of the implemented-component model, thereby creating a printed-board simplified model.

Still further, in yet another embodiment of the device design supporting system according to the present invention, the system includes:
a printed-board model creating unit that creates , from a component model library having stored therein a three-dimensional component model created for each type of component, an implemented-component model to be implemented, and incorporates the implemented-component model in a three-dimensional printed-board model created based on printed-board information to create an implemented-printed-board model;
a high-component model creating unit that creates a component model having a height higher than a height specified from the component models stored in the component model library for reflection onto the implemented-printed-board model; and
a low-component-replacement model creating unit that creates and incorporates, based on a component implementation area of a printed board and the specified height, a single low-component-replacement model that replaces a portion having a height equal to or lower than the specified height of the implemented-component model, thereby creating a printed-board simplified model.

According to the present invention, many component models of the same type are mounted on a printed-board model. Not for implemented-component models on the printed-board model but for component models for each type stored in a component model library, component models having a height equal to or lower than a specified height are deleted. With this, for simplification, the number of component models to be processed can be significantly reduced, and also the processing time required for simplification can be significantly reduced. In this case, component models having a height exceeding the specified height will have a portion having a height equal to or lower than the specified height deleted.

Here, the implemented-component models on the printed-board model have data shared with the component models on the library. Therefore, when data of the component models in the library is deleted, such deletion is reflected onto their corresponding implemented-component models on the printed-board model. Thus, a process of extracting and deleting, from many implemented-component models, those having a height equal to or lower than the specified height is not required, thereby reducing the processing time required for simplifying the printed-board model.

Furthermore, in a deleted portion of a component model on the implemented-printed-board model and a deleted portion of a component model having a height exceeding the specified height, a single low-component-replacement model having a stereoscopic shape formed by moving a component implementation area as a bottom surface by the specified height is incorporated. With this, even for a printed-board simplified model, a maximum area including the deleted component can be represented as a low-component-replacement model. Therefore, at the time of package designing using a simplified model, an error in design, such as interference with a newly-designed component, can be prevented. Still further, interference check can be made at the time of design completion by using a simplified model, thereby reducing the processing time required for design verification.

### Brief Description of Drawings

Figs. 1A and 1B are drawings for describing a conventional three-dimensional CAD system including a conventional simplifying function;
Fig. 2 is a drawing for describing a print board model before simplification;
Fig. 3 is a drawing for describing a conventional simplified model with component models having a height equal to or lower than a specified height being removed;
Fig. 4 is a flowchart of a conventional simplifying process;
Figs. 5A and 5B are block diagrams of a functional structure of a three-dimensional CAD system according to the present invention in which a printed-board model is simplified;
Fig. 6 is a block diagram of a hardware environment of a computer on which the three-dimensional CAD system of Figs. 5A and 5B is achieved;
Figs. 7A, 7B, 7C, and 7D are drawings for describing a lower-component shape deleting process on a component model according to the present invention;
Figs. 8A and 8B are drawings for describing a process of creating a low-component replacement model according to the present invention;
Fig. 9 is a drawing for describing a process of creating a simplified print board model according to the present invention;
Figs. 10A and 10B are drawings for describing the simplifying process as to a specific printed-board model according to the present invention; and
Fig. 11 is a flowchart of a simplifying process according to the present invention.

### Best Mode for Carrying Out the Invention

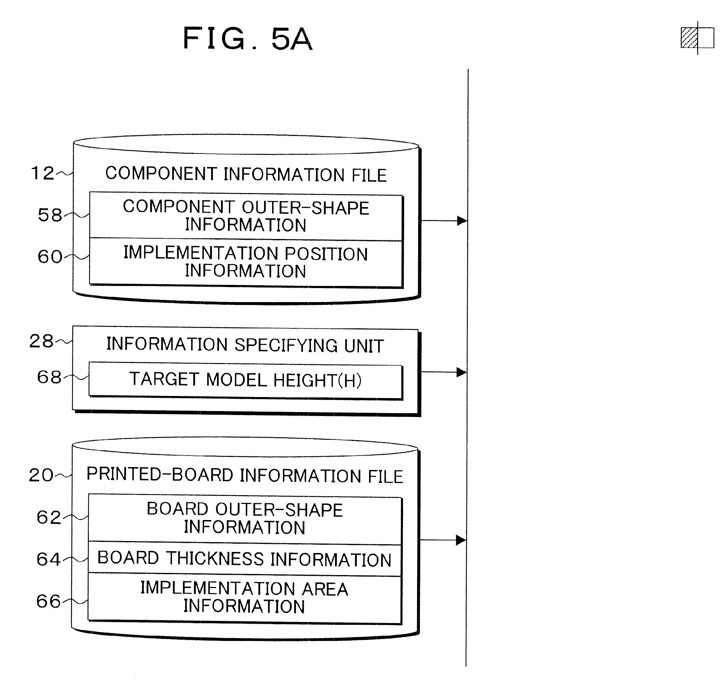

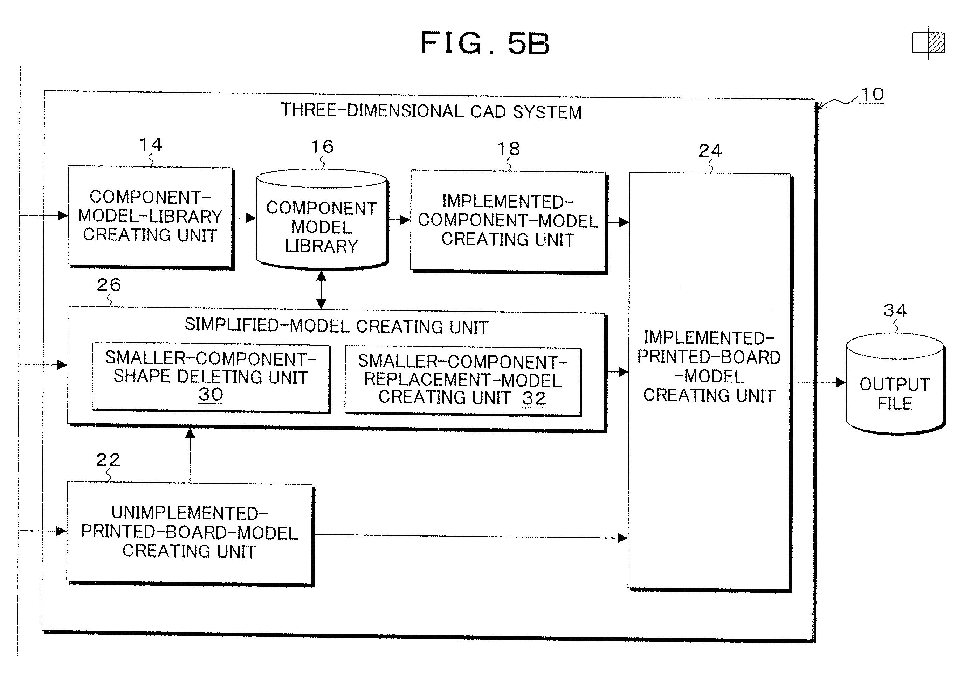

Figs. 5A and 5B are block diagrams of a functional structure of a three-dimensional CAD system according to the present invention in which a printed-board model is simplified. In Figs. 5A and 5B, a three-dimensional CAD system 10 includes a component information file 12, a component-model-library creating unit 14, a component model library 16, an implemented-component-model creating unit 18, an unimplemented-printed-board-model creating unit 22, an implemented-printed-board-model creating unit 24, a simplified-model creating unit 26, and an information specifying unit 28.

The component-model-library creating unit 14 creates a three-dimensional component model for each type of components to be implemented on a printed board based on component information of the component information file 12, and stores the created model in the component model library 16. The component information file 12 has stored therein component outer-shape information 58 and implementation position information 60. Such component information is information created in a data format of, for example, IDF (Intermediate Data Format) known as an industry-standard format regarding board layout.

The implemented-component-model creating unit 18 creates, from the component model library 16, one or plurality of implemented-component models to be implemented on the printed board. Here, data of component models stored in the component model library 16 is shared with one or plurality implemented-component models created by the implemented-component-model creating unit 18. That is, the data of the library component models and data of the implemented-component models are in a shared state.

Such a data sharing state represents a relation in which an implemented-component model specifies the same address as a data storage address of a component model on a memory to which the component model library 16 is assigned. Therefore, when the data contents of the library component model in a data sharing state are changed, this change is reflected on the implemented-component-model creating unit 18 referring to the memory address of the same data. In conjunction with the library component model, the shape of one or plurality of implemented-component models will be changed.

The unimplemented-printed-board-model creating unit 22 creates from the printed-board information stored in the printed-board information file 20, a three-dimensional printed-board model before components are implemented. The printed-board information stored in the printed-board information file 20 includes board outer-shape information 62, board thickness information 64, and implementation area information 66. As with the component information, information having an IDF data format is used for the printed-board information. Here, the implementation area information 66 represents a component implementation allowable area on the printed board, meaning that the other areas are component implementation prohibited areas.

The implemented-printed-board-model creating unit 24 incorporates the implemented-component models created by the implemented-component-model creating unit 18 into the printed-board model created by the unimplemented-printed-board-model creating unit 22 based on the implementation position information 60, thereby creating an implemented-printed-board model.

The simplified-model creating unit 26 is provided with a low-component-shape deleting unit 30 and a low-component-replacement-model creating unit 32. The simplified-model creating unit 26 performs a process of simplifying a representation state of the implemented-component models for the three-dimensional implemented-printed-board model created by the implemented-printed-board-model creating unit 24.

The low- component -shape deleting unit 30 inputs a target model height H specified by the user through an information specifying unit 28, and deletes implemented-component models having a height equal to or lower than the height specified from the implemented-printed-board model and also deletes, for implemented-component models having a height exceeding the specified height H, low-component shapes having a height equal to or lower than the specified height H.

The process of deleting the shape of the component models having a height equal to or lower than the specified height H by the low-component-shape deleting unit 30 is complicated when the process is targeted for the implemented-printed-board models. Therefore in the present invention, the process of deleting the component models having a height equal to or lower than the specified height H is performed as being targeted for the component models in the component model library 16. As a matter of course, for the components having a height exceeding the specified height, low-component shapes having a height equal to or lower than the specified height are deleted.

In this manner, the low-component-shape deleting unit 30 deletes component models having a height equal to or lower than the specified height H for component models for each type stored in the component model library 16, and also deletes low-component shapes having a height equal to or lower than the specified height for components having a height exceeding the specified height H. Since the library component data and the implemented-component models incorporated in the implemented-printed-board model are in a data sharing state, when a data change occurs due to deletion of library component models or deletion of low component shapes by the low-component-shape deleting unit 30, the changed data contents are reflected directly on the implemented-component models in a data sharing state, thereby changing the shapes of the corresponding implemented-component models incorporated in the implemented-printed-board model.

The low-component-replacement-model creating unit 32 creates a single low-component-replacement model that replaces the deleted portions of the component models by the low-component-shape deleting unit 30 and the deleted portions of the low component shapes, based on the implementation area information 66 obtained from the printed-board information file 20 and the specified height H specified by the user through the information specifying unit 28. With the low-component-replacement model being incorporated in the implemented-printed-board model subjected to a deleting process, a printed-board simplified model is created.

The implemented-printed-board model created by the three-dimensional CAD system 10 and the printed-board simplified model created by the simplified-model creating unit 26 are stored in an output file 34 as required. By using the printed-board simplified model in the output file 34, device package designing and others are performed.

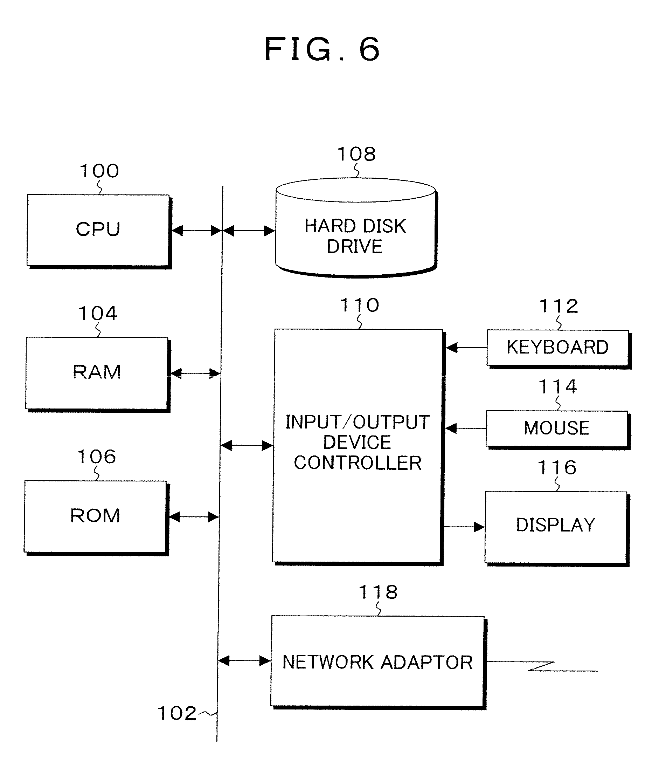

Fig. 6 is a block diagram of a hardware environment of a computer on which the three-dimensional CAD system of Fig. 5A and 5B is achieved. In Fig. 6, a bus 102 of an MPU 100 has connected thereto a RAM 104, a ROM 106, a hard disk drive 108, an input/output device controller 110 having connected thereto a keyboard 112, a mouse 114 , and a display 116, and further a network adaptor 118.

The hard disk drive 108 has loaded therein a three-dimensional CAD program for creating a printed-board simplified model according to the present invention. At the time of activating the computer, the program is called from the hard disk drive 108 to be developed onto the RAM 104 and executed by the MPU 100.

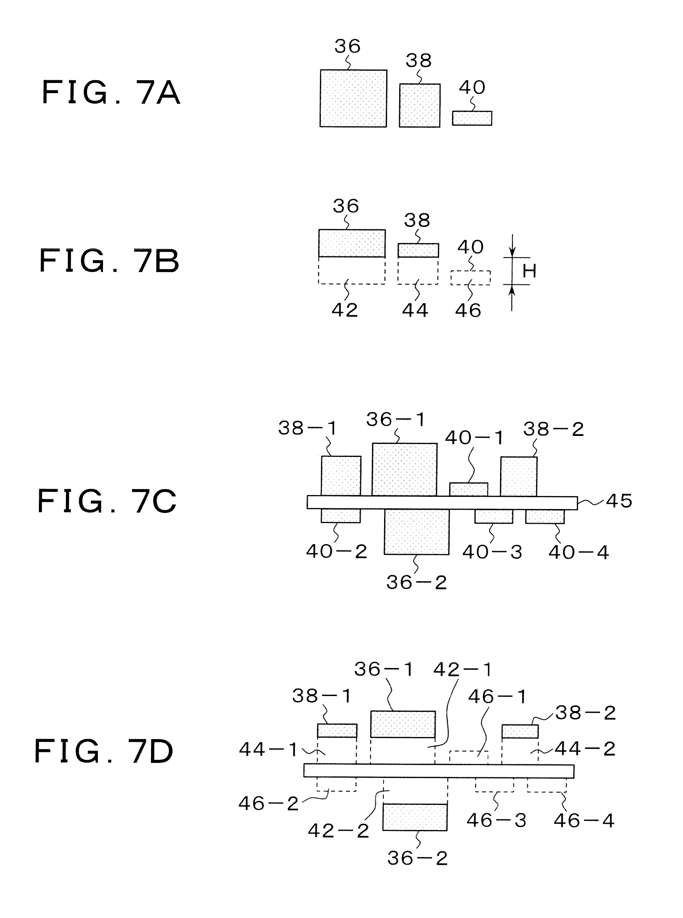

Figs. 7A to 7D are drawings for describing a deleting process by the low-component-shape deleting unit 30 provided to the simplified-model creating unit 26 of Figs. 5A and 5B . Fig. 7A depicts a three-dimensional library component model stored in the component model library 16, showing three types of library component models 36, 38, and 40. Targeted for these library component models 36, 38, and 40, when user specifies the height H for deletion by using the information specifying unit 28, based on the specified height H, a process of deleting portions having a height equal to or lower than the specified height H is performed on each of the library component models 36, 38, and 40 as depicted in Fig. 7B.

With this deleting process, since the library component models 36 and 38 have a height higher than the specified height H, portions having a height equal to or lower than the specified height H are deleted as deleted portions 42 and 44. On the other hand, since the library component model 40 has a height lower than the specified height, the entire portion of the component is taken as a deleted portion 46 and, as a result, the library component model 40 is deleted.

Fig. 7C is a drawing for describing the implemented-printed-board model created by incorporating the implemented component models created based on the library component models 36, 38, and 40 of Fig. 7A into the printed-board model.

In this example, two implemented-component models 36-1 and 36-2 created from the library component model 36 are incorporated on front and rear surfaces of a printed-board model 45, two implemented-component models 38-1 and 38-2 created from the library component model 38 are incorporated on the front side, and four implemented-component models 40-1 to 40-4 created from the library component model 40 are further incorporated on the front and rear surfaces.

With such implemented-printed-board model as depicted in Fig. 7C being created, when a process of deleting portions having a height equal to or lower than the specified height H is performed by the low-component-shape deleting unit 30 as depicted in Fig. 7B, data is changed due to the deleted portions 42, 44, and 46 of the library component models 36, 38, and 40, respectively, having a height equal to or lower than the specified height H. Since the library component models and the implemented-component models are in a data sharing state, the results of the data changes cause the shapes of the library component models 36, 38, and 40 after change to be reflected onto the implemented-component models 36-1,36-2, 38-1, 38-2, and 40-1 to 40-2 incorporated in the printed-board model 45.

Here, since the library component model 40 has having a height equal to or lower than the specified height been deleted, All of the component-implemented models 40-1 to 40-4 that are in a data sharing state on the printed-board model 45 are deleted. Also, the shapes of the implemented-component models 36-1, 36-2, 38-1, and 38-2 corresponding to the library component models 36 and 38 having a height higher than the specified height H are each changed so that a low-component shape having a height equal to or lower than the specified height H is deleted.

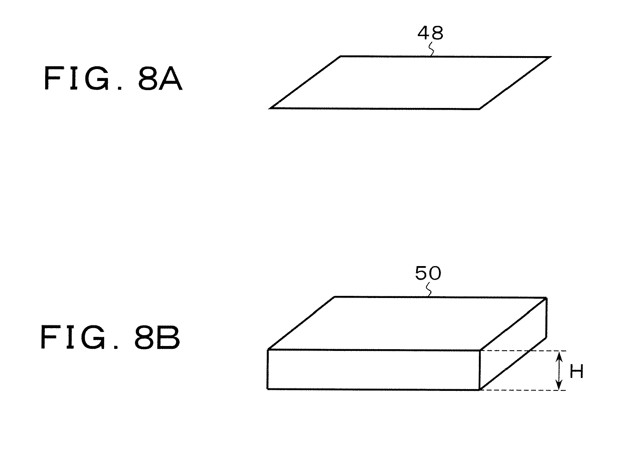

Figs. 8A and 8B are drawings for describing a process of creating a low-component replacement model by the low-component-replacement-model creating unit 32 provided to the simplified-model creating unit 26. Fig. 8A depicts a component implementation area 48 created based on the implementation area information 66 included in the printed-board information. The component implementation area 48 is a two-dimensional model positioned on the front surface of the printed board, that is, on the bottom surface of each component.

This component implementation area 48 on the bottom surface as a two-dimensional model is moved upward by the user-specified height H by the information specifying unit 28 as depicted in Fig. 8B, thereby creating a low-component-replacement model 50 in a three-dimensional shape formed as a moving path. This low-component-replacement model 50 is created for each independent component implementation area on the printed board. A single low-component-replacement model is created unless it is divided by the component-implementation-prohibited area on the printed board.

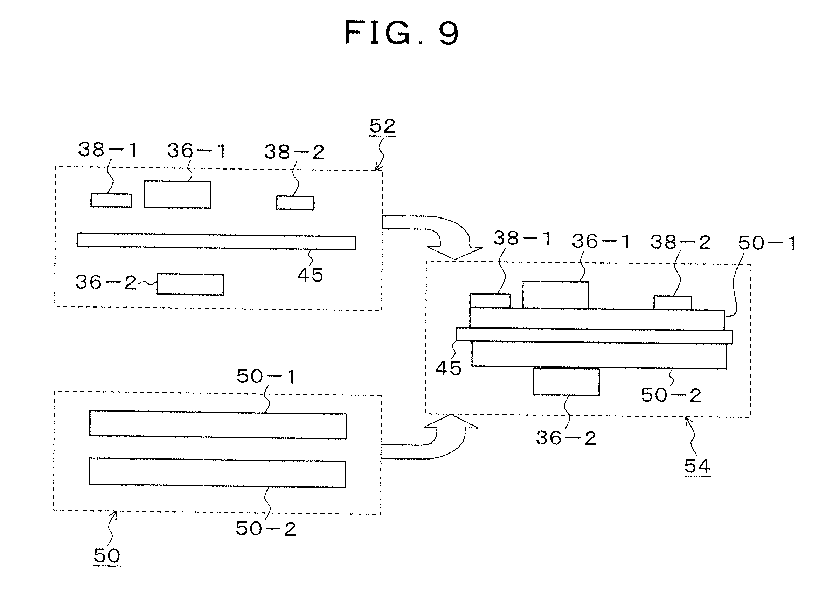

Fig. 9 is a drawing for describing a process of incorporating the low-component-replacement models created by the low-component-replacement-model creating unit 32 of the simplified model creating unit 26 into the low-component-deleted model. In Fig. 9, a low-component-deleted model 52 is a model obtained through deletion of low components having a height equal to or lower than the specified height H from the component models in the component model library 16. On the other hand, the low-component-replacement model 50 is a model as depicted in Fig. 8B having a stereoscopic shape formed by moving the component implementation area 48 as a bottom surface upward by the specified height H.

In this example, components are implemented on the front and rear surface of the printed-board model 45 and then deletion with the specified height H is performed. Therefore, a front-surface low-component-replacement model 50-1 and a rear-surface low-component-replacement model 50-2 are created. Then, in the low-component deleted model 52, two low-component-replacement models 50-1 and 50-2 in the low-component-replacement model 50 are incorporated, thereby creating a printed-board simplified model 54.

In the printed-board simplified model 54, all components having a height equal to or lower than the specified height H are deleted. Also, the component implementation area 48 up to the specified height including the deleted components having a height equal to or lower than the specified height H has disposed thereon the low-component-replacement models 50-1 and 50-2. With this simplified model 54 being used for package designing, since many component models having a height equal to or lower than the specified height H have been all deleted, the amount of data of the component models is significantly reduced. Thus, the process load at the time of representing the printed-boardmodel can be reduced, and the designing capability in package designing using the printed-board simplified model 54 can be maintained.

Also, in the portions from which the component models having a height equal to or lower than the specified height H, the low-component-replacement models 50-1 and 50-2 having a stereoscopic shape defined by the component implementation area and the specified height are incorporated. Therefore, a designer using the printed-board simplified model 54 designs a new component so that the new component does not interfere with the low-component-replacement models 50-1 and 50-2, thereby preventing the occurrence of an error in designing, such as interference, in package designing using the printed-board simplified model 54, for example.

Furthermore, for a process of checking interference after package designing is completed, the printed-board simplified model 54 can be used as it is. Therefore, compared with the case of an interference process where the component models having a height equal to or lower than the specified height H are left without using the low-component-replacement models 50-1 and 50-2, a process load required for an interference process can be significantly reduced, thereby making an interference check within a short period of time.

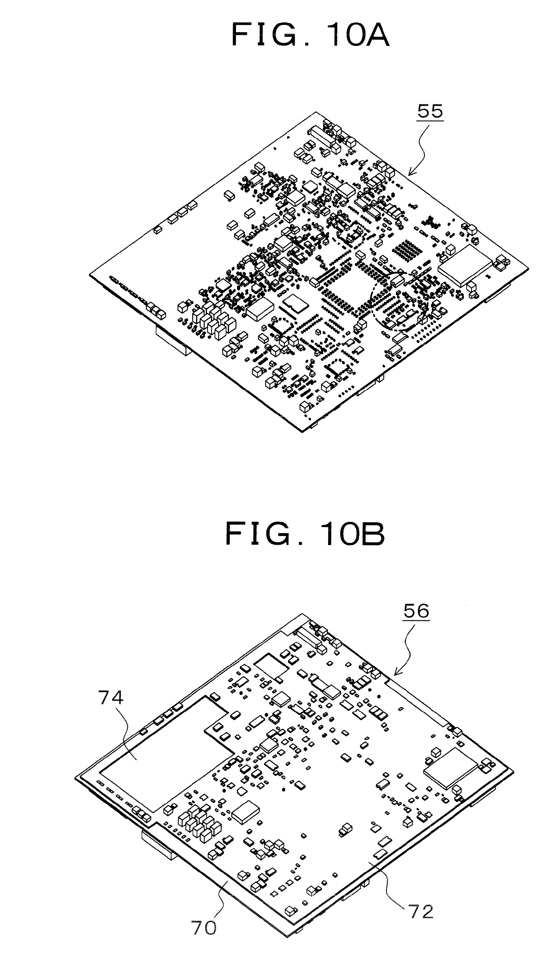

Figs. 10A and 10B are drawings for describing the simplifying process as to a specific printed-board model according to the present invention. Fig. 10A depicts a printed-board model not subjected to a simplifying process, and many component models having a low height are disposed on the printed board. When such a printed-board model 55 is subjected to a low-component-shape deleting process and a low-component-replacement-model creating process by the simplified-model creating unit 26 of Figs. 5A and 5B, a printed-board simplified model 56 can be created, as depicted in Fig. 10B.

In this printed-board simplified model 56, a printed-board model 70 has incorporated thereon a single low-component-replacement model 72 having the specified height H, with component models having a height higher than the specified height H protruding from the low-component-replacement model 72. Also, since a hollow portion at the left corner side of the low-component-replacement model 72 is a component-implementation-prohibited area 74, this portion is eliminated.

When the printed-board simplified model 56 in Fig. 10B is compared with the printed-board model 55 before simplification in Fig. 10A, it can be found that, by deleting the component models having a height equal to or lower than the specified height H, the number of component models represented on the printed-board simplified model 56 is significantly reduced. Also, in the portions of the deleted component models, the low-component-replacement model 72 in a stereoscopic shape having the specified height H is incorporated. Therefore, even if the models having a height equal to or lower than the specified height H are deleted, the presence of the deleted component models can be recognized by the designer withthelow-component-replacementmode172. Thus, an appropriate designing operation can be achieved without causing an interference with a component designed later in package designing using the simplified model 56.

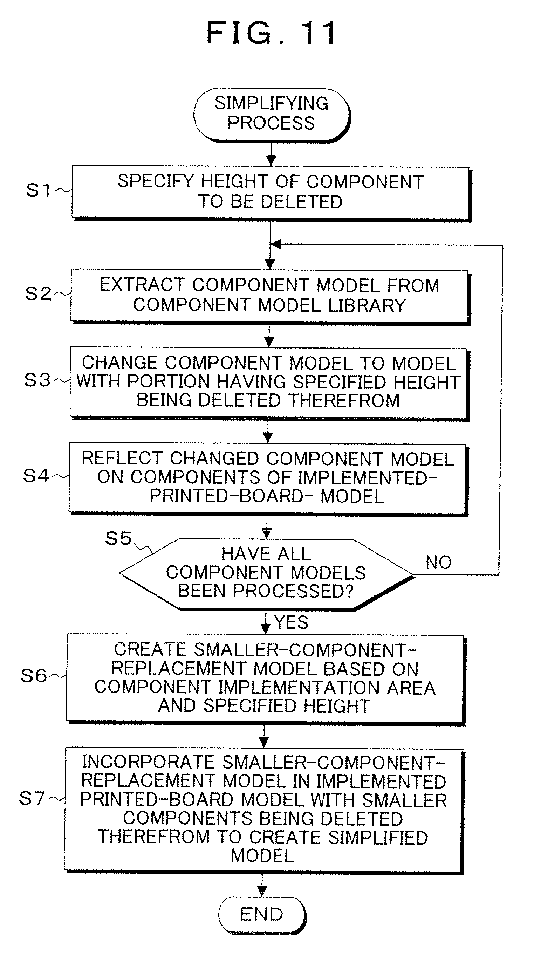

Fig. 11 is a flowchart of a simplifying process by the simplified-model creating unit 26 of Figs. 5A and 5B . In Fig. 11, in the simplifying process, the height of the components to be deleted specified by the user is read at step S1. At step S2, one of the component models stored in the component model library 16 is extracted. At step S3, the component model is changed to a model with a portion having the specified height H being deleted therefrom.

In this case, if the component model has a height equal to or lower than the specified height H, this component model is to be deleted. Also, for a component model having a height higher than the specified height H, the component model is changed to a model with its low-component shape having the specified height H being deleted therefrom.

After this model change is completed, at step S4, the changed component model is reflected on the implemented-component model on the implemented printed board. This is based on a data sharing state. Then at step S5 , it is checked to see whether all component models in the component model library 16 have been processed. If not completed, the procedure returns to step S2 repeating the processes from step S2 until all component models have been processed.

When it is determined at step S5 that all component models in the component model library 16 have been processed, the procedure goes to step S6, where a is created based on the component implementation area and the specified height H. At step S7, the low-component-replacement model is incorporated in the implemented-printed-board model from which the low components are deleted, thereby creating a printed-board simplified model.

Also, the present invention provides a program executed on the computer of Fig. 6 achieving the three-dimensional CAD system of Figs. 5A and 5B. This program executes the flowchart of Fig. 11.

Furthermore, the program for a simplifying process depicted in Fig. 11 is additionally provided to a process routine of a program for creating a printed-board model before simplification, which is a basic function included in the three-dimensional CAD system 10 of Figs. 5A and 5B.

A basic program for creating a printed-board model, that is, a printed-board model creating program, includes the following creation process steps.
(1) A library creating step of creating a three-dimensional component model for each type of component based on component information for storage in a component model library;
(2) An implemented-component model creating step of creating, from the component model library, an implemented-component model to be implemented on the printed board;
(3) An unimplemented-printed-board model creating step of creating a three-dimensional printed-board model from printed-board information; and
(4) An implemented-printed-board model creating step of creating an implemented-printed-board model by incorporating the printed-board model in the unimplemented-component model.

Also, in the above embodiment, a component model having a height equal to or lower than a specified height is deleted by the low-component-shape deleting unit 30 from the component models stored in the component model library and, for a component model having a height exceeding the specified height , a low-component shape having a height equal to or lower than the specified height is deleted to reflect the deletion results onto the implemented-printed-board model. Based on a component implementation area of a printed board and the specified height, a single low-component-replacement model that replaces a deleted portion of the implemented-component model and a deleted portion of the low-component shape is created and incorporated by the low-component-replacement model creating unit 32. With this, a printed-board simplified model is created. As another embodiment of the present invention,
(1) in place of the low-component -replacement model creating unit 32, a high-component-replacement model creating unit that creates a component model having a height higher than a height specified from the component models stored in the component model library 16 for reflection onto the implemented-printed-board model is provided; and
(2) The low-component-replacement model creating unit 32 creates and incorporates, based on a component implementation area of a printed board and the specified height, a single low-component-replacement model that replaces a portion having a height equal to or lower than the specified height of the implemented-component model, thereby creating a printed-board simplified model.

Variations of this device design supporting system can be implemented as a device design supporting method and program, causing the computer to execute the following procedure.
(1) A printed-board model creating step of creating, from a component model library 16 having stored therein a three-dimensional component model created for each type of component, an implemented-component model to be implemented, and incorporating the implemented-component model in a three-dimensional printed-board model created based on printed-board information to create an implemented-printed-board model;
(2) A high-component-replacement model creating step of creating a component model having a height higher than a height specified from the component models stored in the component model library 16 for reflection onto the implemented-printed-board model; and
(3) A low-component-replacement model creating step of creating and incorporating, based on a component implementation area of a printed board and the specified height, a single low-component-replacement model that replaces a portion having a height equal to or lower than the specified height of the implemented-component model, thereby creating a printed-board simplified model.

Here, the present invention includes appropriate modifications without impairing the objects and advantages of the present invention, and is not restricted by numerical values mentioned in the above embodiment.

## Claims

1. A device design supporting method causing a computer to execute the steps comprising:
a printed-board model creating step of creating, from a component model library having stored therein a three-dimensional component model created for each type of component, an implemented-component model to be implemented, incorporating the implemented-component model in a three-dimensional printed-board model created based on printed-board information, and creating an implemented-printed-board model;
a low-component-shape deleting step of deleting a component model having a height equal to or lower than a specified height from the component models stored in the component model library and, for a component model having a height exceeding the specified height, deleting a low-component shape having a height equal to or lower than the specified height to reflect the deletion results onto the implemented-printed-board model; and
a low-component-replacement model creating step of creating and incorporating, based on a component implementation area of the printed board and the specified height, a single low-component-replacement model that replaces a deleted portion of the implemented-component model and a deleted portion of the low-component shape, thereby creating a printed-board simplified model.

2. The device design supporting method according to claim 1, wherein
the implemented-component model incorporated in the implemented-printed-board model shares data of a corresponding component model stored in the component model library, and a shape of the implement component model is changed in conjunction with a shape change of the component model.

3. The device design supporting method according to claim 1, wherein
in the low-component-replacement model creating step,
a low-component-replacement model is created and incorporated, the low-component-replacement model being in a stereoscopic shape formed by moving the component implementation area as a bottom surface by the specified height in a height direction.

4. The device design supporting method according to claim 1, wherein
in the low-component-shape deleting step, the height of the component model to be deleted is a height specified by a user through an information specifying unit.

5. The device design supporting method according to claim 1, wherein
the printed-board model creating step includes:
a library creating step of creating a three-dimensional component model for each type of component based on component information and storing the three-dimensional component model in a component model library;
an implemented-component model creating step of creating, from the component model library, an implemented-component model to be implemented on the printed board;
an unimplemented-printed-board model creating step of creating a three-dimensional printed-board model from printed-board information; and
an implemented-printed-board model creating step of creating an implemented-printed-board model by incorporating the implemented-component model in the printed-board model.

6. A device design supporting program causing a computer to execute the steps comprising:
a printed-board model creating step of creating, from a component model library having stored therein a three-dimensional component model created for each type of component, an implemented-component model to be implemented, and incorporating the implemented-component model in a three-dimensional printed-board model created based on printed-board information to create an implemented-printed-board model;
a low-component-shape deleting step of deleting a component model having a height equal to or lower than a specified height from the component models stored in the component model library and, for a component model having a height exceeding the specified height, deleting a low-component shape having a height equal to or lower than the specified height to reflect the deletion results onto the implemented-printed-board model; and
a low-component-replacement model creating step of creating and incorporating, based on a component implementation area of the printed board and the specified height, a single low-component-replacement model that replaces a deleted portion of the component model and a deleted portion of the low-component shape, thereby creating a printed-board simplified model.

7. The device design supporting program according to claim 6, wherein
the implemented-component model incorporated in the implemented-printed-board model shares data of a corresponding component model stored in the component model library, and a shape of the implement component model is changed in conjunction with a shape change of the component model.

8. The device design supporting program according to claim 6, wherein
in the low-component-replacement model creating step,
a low-component-replacement model is created and incorporated, the low-component-replacement model being in a stereoscopic shape formed by moving the component implementation area as a bottom surface by the specified height in a height direction.

9. The device design supporting program according to claim 6, wherein
in the low-component-shape deleting step, the height of the component model to be deleted is a height specified by a user through an information specifying unit.

10. The device design supporting program according to claim 6, wherein
the printed-board model creating step includes:
a library creating step of creating a three-dimensional component model for each type of component based on component information and storing the three-dimensional component model in a component model library;
an implemented-component model creating step of creating, from the component model library, an implemented-component model to be implemented on the printed board;
an unimplemented-printed-board model creating step of creating a three-dimensional printed-board model from printed-board information; and
an implemented-printed-board model creating step of creating an implemented-printed-board model by incorporating the implemented-component model in the printed-board model.

11. A device design supporting system, comprising:
a printed-board model creating unit that creates, from a component model library having stored therein a three-dimensional component model created for each type of component, an implemented-component model to be implemented, and incorporates the implemented-component model in a three-dimensional printed-board model created based on printed-board information to create an implemented-printed-board model;
a low-component-shape deleting unit that deletes a component model having a height equal to or lower than a specified height from the component models stored in the component model library and, for a component model having a height exceeding the specified height, deletes a low-component shape having a height equal to or lower than the specified height to reflect the deletion results onto the implemented-printed-board model; and
a low-component-replacement model creating unit that creates and incorporating, based on a component implementation area of the printed board and the specified height, a single low-component-replacement model that replaces a deleted portion of the component model and a deleted portion of the low-component shape, thereby creating a printed-board simplified model.

12. The device design supporting system according to claim 11, wherein
the implemented-component model incorporated in the implemented-printed-board model shares data of a corresponding component model stored in the component model library, and a shape of the implement component model is changed in conjunction with a shape change of the component model.

13. The device design supporting system according to claim 11, wherein
the low-component-replacement model creating unit creates and incorporates a low-component-replacement model, the low-component-replacement model being in a stereoscopic shape formed by moving the component implementation area as a bottom surface by the specified height in a height direction.

14. The device design supporting system according to claim 11, wherein
the low-component-shape deleting unit takes the height of the component model to be deleted as a height specified by a user through an information specifying unit.

15. The device design supporting system according to claim 11, wherein
the printed-board model creating unit includes:
a library creating unit that creates a three-dimensional component model for each type of component based on component information and stores the three-dimensional component model in a component model library;
an implemented-component model creating unit that creates, from the component model library, an implemented-component model to be implemented on the printed board;
an unimplemented-printed-board model creating unit that creates a three-dimensional printed-board model from printed-board information; and
an implemented-printed-board model creating unit that creates an implemented-printed-board model by incorporating the implemented-component model in the printed-board model.

16. A device design supporting method causing a computer to execute the steps comprising:
aprinted-boardmodel creating step of creating, from a component model library having stored therein a three-dimensional component model created for each type of component, an implemented-component model to be implemented, and incorporating the implemented-component model in a three-dimensional printed-board model created based on printed-board information to create an implemented-printed-board model;
a high-component model creating step of creating a component model having a height higher than a height specified from the component models stored in the component model library for reflection onto the implemented-printed-board model; and
a low-component-replacement model creating step of creating and incorporating, based on a component implementation area of the printed board and the specified height, a single low-component-replacement model that replaces a portion having a height equal to or lower than the specified height of the implemented-component model, thereby creating a printed-board simplified model.

17. A program causing a computer to execute the steps comprising:
a printed-board model creating step of creating, from a component model library having stored therein a three-dimensional component model created for each type of component, an implemented-component model to be implemented, and incorporating the implemented-component model in a three-dimensional printed-board model created based on printed-board information to create an implemented-printed-board model;
a high-component model creating step of creating a component model having a height higher than a height specified from the component models stored in the component model library for reflection onto the implemented-printed-board model; and
a low-component-replacement model creating step of creating and incorporating, based on a component implementation area of a printed board and the specified height, a single low-component-replacement model that replaces a portion having a height equal to or lower than the specified height of the implemented-component model, thereby creating a printed-board simplified model.

18. A device design supporting system, comprising:
a printed-board model creating unit that creates , from a component model library having stored therein a three-dimensional component model created for each type of component, an implemented-component model to be implemented, and incorporates the implemented-component model in a three-dimensional printed-board model created based on printed-board information to create an implemented-printed-board model;
a high-component model creating unit that creates a component model having a height higher than a height specified from the component models stored in the component model library for reflection onto the implemented-printed-board model; and
a low-component-replacement model creating unit that creates and incorporates, based on a component implementation area of a printed board and the specified height, a single low-component-replacement model that replaces a portion having a height equal to or lower than the specified height of the implemented-component model, thereby creating a printed-board simplified model.
